# EUROPEAN PATENT SPECIFICATION

(11) **EP 3 013 483 B1**
(45) Date of publication and mention of the grant of the patent: **26.05.2021**
(21) Application number: 14847820.9
(22) Date of filing: 27.06.2014
(51) Int. Cl.: B32B 37/12, H01L 51/44, B32B 38/18, B29C 63/02

(54) **COATING FOR AIRCRAFT FUSELAGE SURFACES TO PRODUCE ELECTRICITY FOR MISSION-CRITICAL SYSTEMS ON MILITARY AIRCRAFT**
BESCHICHTUNG FÜR FLUGZEUGRUMPFOBERFLÄCHEN ZUR ERZEUGUNG VON ELEKTRIZITÄT FÜR MISSIONSKRITISCHE SYSTEME IN KAMPFFLUGZEUGEN
REVÊTEMENT POUR SURFACES DE FUSELAGE D'AVION DESTINÉ À PRODUIRE DE L'ÉLECTRICITÉ POUR DES SYSTÈMES INDISPENSABLES À UNE MISSION SUR UN AVION MILITAIRE

(30) Priority: 28.06.2013 US 201361841243 P; 28.06.2013 US 201361841244 P; 28.06.2013 US 201361841247 P; 28.06.2013 US 201361841248 P; 28.06.2013 US 201361841251 P; 02.07.2013 US 201361842355 P; 02.07.2013 US 201361842357 P; 02.07.2013 US 201361842365 P; 02.07.2013 US 201361842372 P; 02.07.2013 US 201361842375 P; 03.07.2013 US 201361842796 P; 03.07.2013 US 201361842803 P
(43) Date of publication of application: 04.05.2016
(73) Proprietor: New Energy Technologies, Inc., Columbia, MD 21044 (US); Conklin, John, Anthony, Apalachin, NY 13732 (US); Hammond, Scott, Ryan, Wheat Ridge, CO 80215 (US); Thompson, J., Patrick, Canton, GA 30114 (US)
(72) Inventor: CONKLIN, John Anthony, Apalachin, NY 13732 (US); HAMMOND, Scott Ryan, Wheat Ridge, CO 80215 (US); THOMPSON, Patrick J., Canton, GA 30114 (US)
(74) Representative: Qip Patentanwälte Dr. Kuehn & Partner mbB
(86) International application number: PCT/US2014/044645
(87) International publication number: WO 2015/047504

(56) References cited:
- WO-A1-2013/045466
- WO-A2-2012/154803
- US-A1- 2008 142 238
- US-A1- 2008 295 889
- US-A1- 2009 008 507
- US-A1- 2009 229 667
- US-A1- 2013 002 015
- US-B1- 8 448 898
- KALTENBRUNNER M ET AL: "Ultrathin and lightweight organic solar cells with high flexibility", NATURE COMMUNICATIONS, NATURE PUBLISHING GROUP, UNITED KINGDOM , 3 April 2012 (2012-04-03), pages 1-7, XP002682520, ISSN: 2041-1723, DOI: 10.1038/NCOMMS1772 Retrieved from the Internet: URL:http://www.nature.com/ncomms/journal/v 3/n4/full/ncomms1772.html [retrieved on 2012-04-03]

## Description

The present invention is directed to the use of organic photovoltaic devices - cell or modules - as coatings for military aircraft fuselage, wing, tail, and strut surfaces, to provide electricity for mission-critical systems on-board the aircraft.

### BACKGROUND OF THE INVENTION

Modern military aircraft are highly technologically advanced vehicles that must perform a variety of duties under very demanding conditions. Energy efficiency and energy consumption are of minimal concern in such vehicles, but the military is constantly looking to make every surface into an active one, through the use of advanced materials. Despite this, the majority of military aircraft surfaces (fuselage, wing, tail, strut, etc.) remain largely passive, non-functional surfaces. If value could be added to these surfaces by making them contribute to the overall mission-capability of the aircraft by producing electrical energy, it would be a significant improvement, regardless of cost US 2009/0229667 A1 does not disclose application of an electricity-generating coating onto a window surface of an aircraft by means of a pressure-sensitive adhesive.

### SUMMARY OF THE INVENTION

The present invention recognizes that one way to add functionality to aircraft surfaces is by covering them in photovoltaics (PV), which can provide electricity to help power mission-critical systems on-board the aircraft. Traditional inorganic PV makes little sense for aircraft applications for a number of reasons, however, including excessive weight and potentially bulky structures that could increase wind resistance, both of which would reduce fuel efficiency. Organic PV (OPV) has a number of features that makes it potentially attractive for application in military aircraft, including low specific weight (W/g), flexibility, and thickness of the thin films. An important feature is the very low specific weight of OPV, as compared to other PV technologies, which could minimize any impact on fuel efficiency. Additionally, OPV is inherently flexible, which potentially allows unique application methods for non-planar surfaces, such as curved fuselage surfaces. Furthermore, the tunable nature of the absorption in OPV materials allows customized power production and surface appearances, which can be important for specialized military aircraft.

The present invention recognizes that conventional military aircraft surfaces, such as fuselage, wing, tail, and strut surfaces (hereafter referred to simply as fuselage surfaces), are generally passive surfaces that do not contribute actively to the mission-capability of the aircraft.

These problems and others are addressed by the present invention as defined in the appended claims. An exemplary embodiment of the electricity-generating coating can be applied as a film to conventional military aircraft surfaces. In this embodiment, the OPV coating is applied as a completed device onto the aircraft surface using a thin, flexible substrate with pressure-sensitive adhesives, which is described in detail in Applicants' related applications. In such a fashion, the OPV device can be fabricated in a high-throughput manner via roll-to-roll manufacturing onto a flexible planar substrate (with backing material, if necessary) that is then applied to both planar and curved aircraft surfaces. The OPV device can then be wired into the electrical systems via small connection terminals in, or below, the aircraft surface, and any necessary power electronics, such as inverters, batteries, and the like can be located inside the aircraft. The top surface of the OPV device-coated aircraft is then via a protective hard clear-coat (e.g. a clear epoxy coating), to protect the OPV device from physical damage and environmental stress, and from moisture and oxygen ingress, ensuring a superior lifetime. In such a way, the surfaces of the aircraft can be turned into electricity-generating surfaces to help power mission-critical systems, while adding minimal weight, and resulting in a smooth, hard, low-drag surface, to minimize any loss of fuel efficiency. Furthermore, by selecting appropriate OPV material absorption properties, the surface visual effect can be matched to the aircraft design profile, while still generating power.

Another exemplary embodiment of the invention can be fabricated directly on the conventional aircraft surfaces, before assembly of the aircraft. In this embodiment, the surfaces are coated via one or more of a number of techniques, such techniques as: spray, curtain, slot-die, gravure, etc. depending on the curvature of the aircraft surface being coated. Spray and curtain coating can be utilized for curved surfaces, while slot-die and gravure coating can be used for planar surfaces. First, an insulating layer is deposited to allow isolation of the individual cells from each other and from the metal aircraft surfaces, to prevent electrification of the entire aircraft body. Then, the rest of the OPV device is deposited as usual via the appropriate coating and patterning techniques, as known to those skilled in the art of OPV, to produce a completed device directly on the aircraft surface. Again, wiring is accomplished via small terminals on, or below, the aircraft surface, and a hard top clear-coat (e.g., epoxy), is applied to provide a hard, low-drag surface that protects the OPV device. Such completed OPV-coated aircraft surface panels can then be assembled directly on the aircraft body, with wiring and any necessary power electronics, such as inverters and batteries, placed inside the aircraft body to produce a military aircraft with electricity-producing surfaces to help power mission-critical systems on-board.

Other features and advantages of the present invention will become apparent to those skilled in the art upon review of the following detailed description and drawings.

### BRIEF DESCRIPTION OF THE DRAWINGS

These and other aspects and features of embodiments of the present invention will be better understood after a reading of the following detailed description, together with the attached drawings, wherein:
Figure 1 is a cross-sectional view of a pressure-sensitive adhesive-coated organic photovoltaic device, itself coated on a thin flexible substrate with a transfer release layer and rigid backing layer, which can be used to prepare planar and curved organic photovoltaic device-covered military aircraft fuselage surfaces, according to an exemplary embodiment of this invention, as well as Applicant's related application.
Figure 2 is a cross-sectional view of an organic photovoltaic device coated onto a planar military aircraft fuselage surface using the pressure-sensitive adhesive method according to an exemplary embodiment of the invention.
Figure 3 is a cross-sectional view of an organic photovoltaic device coated onto a curved military aircraft fuselage surface using the pressure-sensitive adhesive method according to an exemplary embodiment of the invention.
Figure 4 is a cross-sectional view of an organic photovoltaic device coated directly onto a planar military aircraft fuselage surface using conventional coating methods according to an exemplary embodiment of the invention.

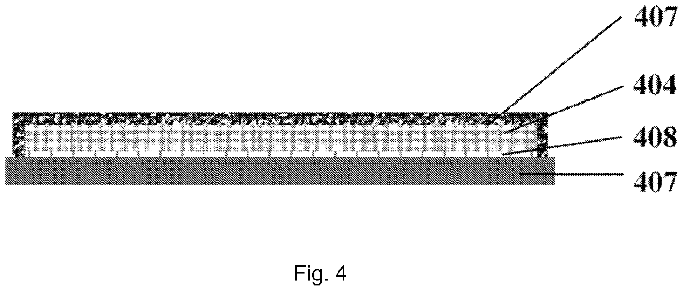

Figure 4 is a cross-sectional view of an organic photovoltaic device coated directly onto a curved military aircraft fuselage surface using conventional coating methods according to an exemplary embodiment of the invention.

### DETAILED DESCRIPTION OF THE EXEMPLARY EMBODIMENTS OF THE INVENTION

The present invention now is described more fully hereinafter with reference to the accompanying drawings, in which embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art.

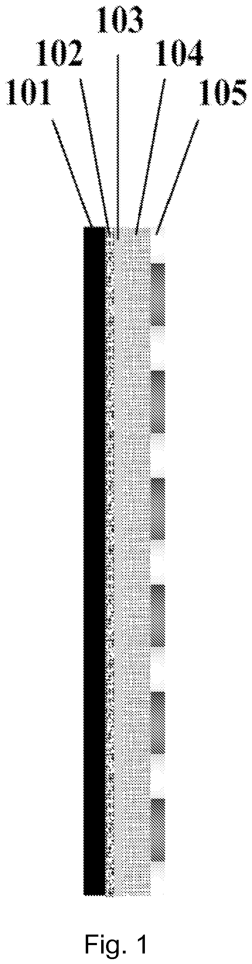

Referring now to the drawings, Figures 1-5 illustrate exemplary embodiments of electricity-generating coatings for military aircraft fuselage surfaces (Figures 4-5) and their manufacture (Figure 1).

Referring to Fig. 1, which provides a cross-sectional view of an intermediate film stack produced for the eventual fabrication of electricity-generating coatings for military aircraft fuselage surfaces, the film is prepared upon a temporary base layer 101, in order to provide sufficient rigidity to allow conventional manufacturing techniques, including high-speed roll-to-roll coating. The base layer can include of thick polymer foils, metal foils, glass substrates, or any convenient substrate material, depending on the chosen manufacturing methods. On top of the base layer is a transfer release layer 102 that allows easy removal of the base layer and transfer layer from the thin flexible substrate 103, which are all laminated together as known to those skilled in the art. The thin flexible substrate is any appropriate substrate material that is highly flexible and transparent, such as very thin polymer foils, including but not limited to polyethyleneterephthalate (PET). On top of this is coated an OPV device, comprising one or more cells connected in series and/or parallel, which is inherently flexible and thus contains no highly crystalline materials. The multi-layered OPV device is coated and processed according to standard methods known to those skilled in the art, such as slot-die coating and laser scribing, which are compatible with high-throughput manufacturing techniques, including high-speed roll-to-roll or sheet-to-sheet production methods. Finally, the OPV device is coated on top with a semitransparent pressure-sensitive adhesive according to methods know to those skilled in the art. The resulting film comprising layers 101-105 can be used to transfer the OPV device comprising layers 103-105 onto military aircraft fuselage surfaces to convert them into electricity-generating fuselage surfaces.

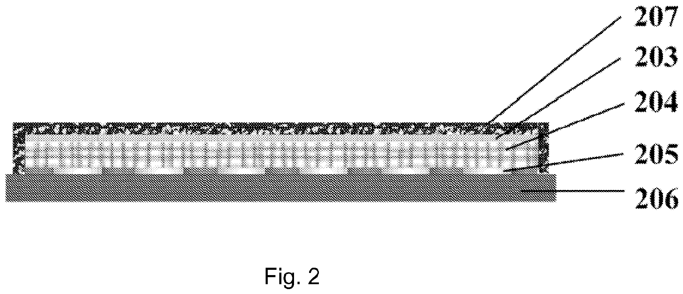

Referring to Fig. 2, which provides a cross-sectional view of a planar electricity-generating military aircraft fuselage surface produced via the pressure-sensitive adhesive method, the base layer 206 includes a conventional military aircraft fuselage panel. Laminated onto the fuselage panel using stretching and press-forming, with or without vacuum assistance in removing entrained air, is the electricity-generating OPV device 204, which is adhered to the panel using the pressure-sensitive adhesive layer 205, and is supported by the thin flexible substrate layer 203. Finally, the whole OPV device is protected via a clear hard-coat 207 (e.g. a clear epoxy), which can be applied via a variety of techniques known to those skilled in the art, such as spray coating. While, in this exemplary embodiment, the method is necessarily a discrete object process for the fabrication of each individual fuselage panel, the intermediate transfer film (see Fig. 1) used to transfer the completed OPV device onto the panel can be produced in a continuous, high-throughput methodology. Not shown are any wires or other electrical contacts, or any power circuitry (e.g. inverters), which would be contained largely within the aircraft body.

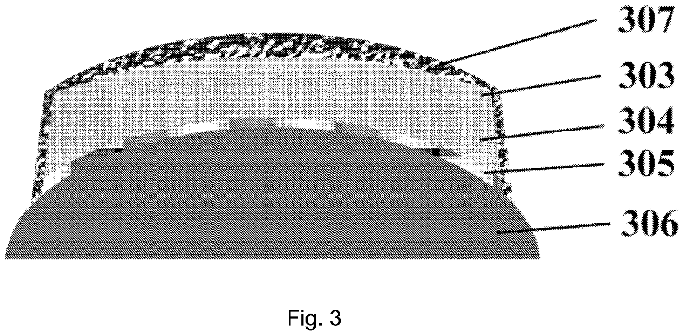

Referring to Fig. 3, which provides a cross-sectional view of a curved electricity-generating military aircraft fuselage surface produced via the pressure-sensitive adhesive method, the base layer 306 includes a conventional curved military aircraft fuselage surface. Laminated onto the fuselage panel using stretching and press-forming, with or without vacuum assistance in removing entrained air, is the electricity-generating OPV device 304, which is adhered to the panel using the pressure-sensitive adhesive layer 305, and is supported by the thin flexible substrate layer 303. Finally, the whole OPV device is protected via a clear hard-coat 307 (e.g. a clear epoxy), which can be applied via a variety of techniques known to those skilled in the art, such as spray coating. The unique and inherent flexibility of OPV devices allows lamination onto curved surfaces without significant disruption of device performance, and enables production of three-dimensional OPV devices that would be difficult to produce via conventional coating techniques due to realities of capillarity flow on curved surfaces. This method enables OPV devices to be laminated onto surfaces of arbitrary and changing curvature, which would be impossible via conventional solution coating techniques. While, in this exemplary embodiment, the method is necessarily a discrete object process for the fabrication of each individual fuselage panel, the intermediate transfer film (see Fig. 1) used to transfer the completed OPV device onto the panel can be produced in a continuous, high-throughput methodology. Not shown are any wires or other electrical contacts, or any power circuitry (e.g. inverters), which would be contained largely within the aircraft body.

Referring to Fig. 4, which provides a cross-sectional view of a planar electricity-generating military aircraft fuselage surface produced via the conventional coating method, the base layer 406 includes a conventional military aircraft fuselage surface. First, the fuselage surface is coated with an insulating layer 408 using methods known to those skilled in the art, to allow isolation of the individual cells from each other and from the aircraft body, preventing electrification of the entire aircraft body. The OPV device 404 is then coated onto the insulating layer using conventional coating techniques such as known to those skilled in the art. Finally, the whole OPV device is protected via a clear hard-coat 407 (e.g. a clear epoxy), which can be applied via a variety of techniques known to those skilled in the art, such as spray coating. While this method has the advantage of having less extraneous layers and materials involved as compared to the laminated processes (see Fig. 2), in this exemplary embodiment, it is necessarily a sheet-to-sheet coating process performed on a panel-by-panel basis for every individual layer in the OPV device, which can limit throughput and increase defects, compared to producing the OPV device in a continuous process (see Fig. 1). Not shown are any wires or other electrical contacts, or any power circuitry (e.g. inverters), which would be contained largely within the aircraft body.

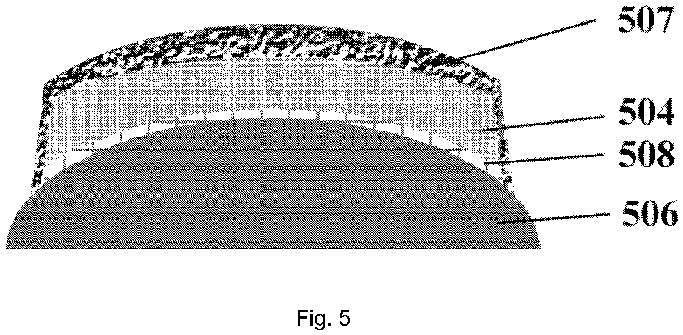

Referring to Fig. 5, which provides a cross-sectional view of a curved electricity-generating military aircraft fuselage surface produced via the conventional coating method, the base layer 506 includes a conventional military aircraft fuselage surface. First, the fuselage surface is coated with an insulating layer 508 using methods known to those skilled in the art, to allow isolation of the individual cells from each other and from the aircraft body, preventing electrification of the entire aircraft body. The OPV device 504 is then coated onto the insulating layer using conventional coating techniques such as spray or curtain coating. Finally, the whole OPV device is protected via a clear hard-coat 507 (e.g. a clear epoxy), which can be applied via a variety of techniques known to those skilled in the art, such as spray coating. While the realities of capillarity flow make precision coating of the very thin layers in OPV devices very difficult, it is possible to overcome these limitations, as least for surfaces with relatively uniform curvature. Doing so repeated for the several layers in an OPV device remains a significant challenge, however, and it is currently impossible for surfaces with varying or very high curvature. As such, the pressure-sensitive adhesive lamination method presents an attractive alternative for the production of curved fuselage surfaces (see Fig. 3).

The present invention has been described herein in terms of several preferred embodiments. However, modifications and additions to these embodiments will become apparent to those of ordinary skill in the art upon a reading of the foregoing description. It is intended that all such modifications and additions comprise a part of the present invention to the extent that they fall within the scope of the several claims appended hereto.

## Claims

1. An electricity-generating coating for a surface of a fuselage panel (206, 306, 406, 506) of a military aircraft, comprising:
a conformal organic photovoltaic device (104, 204, 304, 404, 504), including one or more cells connected in series and/or parallel, wherein the conformal organic photovoltaic device (104, 204, 304, 404, 504) is configured to be adhered to the surface of the fuselage panel (206, 306, 406, 506) of the military aircraft, along with wires and power electronics to allow the conformal organic photovoltaic device (104, 204, 304, 404, 504) to provide electricity for electrical systems on-board the military aircraft;
a pressure-sensitive adhesive (105, 205, 305) on the conformal organic photovoltaic device (104, 204, 304, 404, 504), the pressure-sensitive adhesive (105, 205, 305) being capable of adhering the conformal organic photovoltaic device (104, 204, 304, 404, 504) to the surface of the fuselage panel (206, 306, 406, 506) of the military aircraft, wherein the pressure-sensitive adhesive (105, 205, 305) is semitransparent; and
a very thin, highly flexible transparent substrate (103, 203, 403),
wherein the conformal organic photovoltaic device (104, 204, 304, 404, 504) is covered by the very thin, highly flexible transparent substrate (103, 203, 403).

2. The electricity-generating coating of claim 1, wherein the conformal organic photovoltaic device (104, 204, 304, 404, 504) is protected by a hard, clear top-coat material (207, 307, 407, 507).

3. The electricity-generating coating of claim 2, wherein the surface of the fuselage panel (206, 306, 406, 506) of the military aircraft comprises a planar surface (206, 406).

4. The electricity-generating coating of claim 2, wherein the surface of the fuselage panel (206, 306, 406, 506) of the military aircraft comprises a curved surface (306, 506).

5. The electricity-generating coating of claim 1, wherein the surface of the fuselage panel (206, 306, 406, 506) is coated in an insulating material (408, 508), and
wherein the conformal organic photovoltaic device (104, 204, 304, 404, 504) is configured to be coated on the insulating material (408, 508).

6. The electricity-generating coating of claim 5, further comprising:
a hard, clear top-coat material (207, 307, 407, 507) on the conformal organic photovoltaic device (104, 204, 304, 404, 504),
wherein the hard, clear top-coat material (207, 307, 407, 507) is configured to protect the conformal organic photovoltaic device (104, 204, 304, 404, 504).

7. The electricity-generating coating of claim 6, wherein the surface of the fuselage panel (206, 306, 406, 506) is completely planar.

8. The electricity-generating coating of claim 6, wherein the surface of the fuselage panel (206, 306, 406, 506) is curved.

## Patentansprüche

1. Elektrizitätserzeugende Beschichtung für eine Oberfläche eines Rumpfpaneels (206, 306, 406, 506) eines Militärflugzeugs, umfassend:
eine konforme organische photovoltaische Vorrichtung (104, 204, 304, 404, 504), die eine oder mehrere Zellen umfasst, die in Reihe und/oder parallel geschaltet sind, wobei die konforme organische photovoltaische Vorrichtung (104, 204, 304, 404, 504) dafür eingerichtet ist, zusammen mit Drähten und Leistungselektronik an die Oberfläche des Rumpfpaneels (206, 306, 406, 506) des Militärflugzeugs geklebt zu werden, damit die konforme organische photovoltaische Vorrichtung (104, 204, 304, 404, 504) Elektrizität für elektrische Systeme an Bord des Militärflugzeugs bereitstellen kann;
einen drucksensitiven Klebstoff (105, 205, 305) auf der konformen organischen photovoltaischen Vorrichtung (104, 204, 304, 404, 504), wobei der drucksensitive Klebstoff (105, 205, 305) in der Lage ist, die konforme organische photovoltaische Vorrichtung (104, 204, 304, 404, 504) an die Oberfläche des Rumpfpaneels (206, 306, 406, 506) des Militärflugzeugs zu kleben,
wobei der drucksensitive Klebstoff (105, 205, 305) semitransparent ist; und
ein sehr dünnes, hochflexibles transparentes Substrat (103, 203, 403),
wobei die konforme organische photovoltaische Vorrichtung (104, 204, 304, 404, 504) durch das sehr dünne, hochflexible transparente Substrat (103, 203, 403) bedeckt ist.

2. Elektrizitätserzeugende Beschichtung nach Anspruch 1, wobei die konforme organische photovoltaische Vorrichtung (104, 204, 304, 404, 504) durch ein hartes, klares Deckschichtmaterial (207, 307, 407, 507) geschützt ist.

3. Elektrizitätserzeugende Beschichtung nach Anspruch 2, wobei die Oberfläche des Rumpfpaneels (206, 306, 406, 506) des Militärflugzeugs eine planare Oberfläche (206, 406) umfasst.

4. Elektrizitätserzeugende Beschichtung nach Anspruch 2, wobei die Oberfläche des Rumpfpaneels (206, 306, 406, 506) des Militärflugzeugs eine gekrümmte Oberfläche (306, 506) umfasst.

5. Elektrizitätserzeugende Beschichtung nach Anspruch 1, wobei die Oberfläche des Rumpfpaneels (206, 306, 406, 506) mit einem isolierenden Material (408, 508) beschichtet ist und
wobei die konforme organische photovoltaische Vorrichtung (104, 204, 304, 404, 504) dafür eingerichtet ist, auf das isolierende Material (408, 508) beschichtet zu werden.

6. Elektrizitätserzeugende Beschichtung nach Anspruch 5, des Weiteren umfassend:
ein hartes, klares Deckschichtmaterial (207, 307, 407, 507) auf der konformen organischen photovoltaischen Vorrichtung (104, 204, 304, 404, 504),
wobei das harte, klare Deckschichtmaterial (207, 307, 407, 507) dafür eingerichtet ist, die konforme organische photovoltaische Vorrichtung (104, 204, 304, 404, 504) zu schützen.

7. Elektrizitätserzeugende Beschichtung nach Anspruch 6, wobei die Oberfläche des Rumpfpaneels (206, 306, 406, 506) vollständig planar ist.

8. Elektrizitätserzeugende Beschichtung nach Anspruch 6, wobei die Oberfläche des Rumpfpaneels (206, 306, 406, 506) gekrümmt ist.

## Revendications

1. Revêtement générateur d'électricité pour surface de panneau de fuselage (206, 306, 406, 506) d'un aéronef militaire, comprenant :
un dispositif photovoltaïque organique conformé (104, 204, 304, 404, 504) comportant une ou plusieurs cellules connectées en série et/ou en parallèle, dans lequel le dispositif photovoltaïque organique conformé (104, 204, 304, 404, 504) est conçu pour adhérer à la surface du panneau de fuselage (206, 306, 406, 506) de l'aéronef militaire, conjointement avec des fils et électronique de puissance pour permettre au dispositif photovoltaïque organique conformé (104, 204, 304, 404, 504) de fournir de l'électricité destinée à des systèmes électriques à bord de l'aéronef militaire ;
un adhésif sensible à la pression (105, 205, 305) sur le dispositif photovoltaïque organique conformé (104, 204, 304, 404, 504), l'adhésif sensible à la pression (105, 205, 305) étant apte à faire adhérer le dispositif photovoltaïque organique conformé (104, 204, 304, 404, 504) à la surface du panneau de fuselage (206, 306, 406, 506) de l'aéronef militaire,
dans lequel l'adhésif sensible à la pression (105, 205, 305) est semi-transparent ; et
un substrat transparent très mince, hautement flexible (103, 203, 403),
dans lequel le dispositif photovoltaïque organique conformé (104, 204, 304, 404, 504) est recouvert par le substrat transparent très mince, hautement flexible (103, 203, 403).

2. Revêtement générateur d'électricité, selon la revendication 1, dans lequel le dispositif photovoltaïque organique conformé (104, 204, 304, 404, 504) est protégé par un matériau de couche de finition dur, incolore (207, 307, 407, 507).

3. Revêtement générateur d'électricité, selon la revendication 2, dans lequel la surface du panneau de fuselage (206, 306, 406, 506) de l'aéronef militaire comprend une surface plane (206, 406).

4. Revêtement générateur d'électricité, selon la revendication 2, dans lequel la surface du panneau de fuselage (206, 306, 406, 506) de l'aéronef militaire comprend une surface incurvée (306, 506).

5. Revêtement générateur d'électricité, selon la revendication 1, dans lequel la surface du panneau de fuselage (206, 306, 406, 506) est revêtue d'un matériau isolant (408, 508), et
dans lequel le dispositif photovoltaïque organique conformé (104, 204, 304, 404, 504) est conçu pour être appliqué sur le matériau isolant (408, 508).

6. Revêtement générateur d'électricité, selon la revendication 5, comprenant en outre :
un matériau de couche de finition dur, incolore (207, 307, 407, 507) sur le dispositif photovoltaïque organique conformé (104, 204, 304, 404, 504),
dans lequel le matériau de couche de finition dur, incolore (207, 307, 407, 507) est conçu pour protéger le dispositif photovoltaïque organique conformé (104, 204, 304, 404, 504).

7. Revêtement générateur d'électricité, selon la revendication 6, dans lequel la surface du panneau de fuselage (206, 306, 406, 506) est complètement plane.

8. Revêtement générateur d'électricité, selon la revendication 6, dans lequel la surface du panneau de fuselage (206, 306, 406, 506) est incurvée.
